Europäisches Patentamt

**European Patent Office**

**Office européen des brevets**

(11) Publication number: **0 250 195**
**A2**

## EUROPEAN PATENT APPLICATION

(21) Application number: **87305291.4**

(51) Int. Cl.⁴: **C25D 1/04**

(22) Date of filing: **15.06.87**

(30) Priority: **20.06.86 US 877211**
**23.04.87 US 41606**

(43) Date of publication of application:
**23.12.87 Bulletin 87/52**

(84) Designated Contracting States:
**CH DE FR GB IT LI SE**

(71) Applicant: **GOULD INC.**
**10 Gould Center**
**Rolling Meadows, IL 60008(US)**

(72) Inventor: **Peckham, Peter**
**7113 Brightwood Drive**
**Concord Ohio 44077(US)**

(74) Representative: **Barrett, James William et al**
**A.A. THORNTON & CO. Northumberland**
**House 303-306 High Holborn**
**London WC1V 7LE(GB)**

(54) **Double matte finish copper foil.**

(57) The present invention provides a novel copper foil wherein both surfaces have a matte finish. The double matte foil of the present invention is produced by depositing a first layer of copper foil, of a predetermined thickness, using conventional electrodeposition techniques; removing the foil from the plating drum, and then depositng a second layer of copper foil onto the smooth surface of the first copper foil layer, thereby producing a composite foil having two matte finish sides.

EP 0 250 195 A2

## DOUBLE MATTE FINISH COPPER FOIL

The present invention relates to the art of electroplating and more particularly to an electrodeposited copper foil having a roughened or "matte" surface on both sides, which has particular utility in manufacturing multilayered printed circuit boards.

Conventional electrodeposited copper foil has heretofore had a smooth surface on the side of the foil which was in contact with the plating drum, and a rough or "matte" finish on the other surface. Typically the matte side has an average roughness about 5 to 10 micrometers though it may be 15 to 20 micrometers or more, or conversely, 2 to 3 micrometers or less. It is well known that in producing printed circuit board laminates, substantially improved adhesion can be obtained between the copper foil and the circuit board substrate by bonding the "matte" surface of the copper foil on the substrate.

With the advent of multilayering, that is to say stacks or sandwiches of a plurality of alternating layers of copper foil and substrate, it is necessary to bond the copper foil not merely to a single substrate, but to two substrates, one above, and one below each layer of copper foil. Thus one substrate is bonded to the matte surface, while the second substrate is bonded to the so-called smooth foil surface. As might be expected many problems have been encountered in adhesion between the smooth surface and its adjacent substrate. For example, as measured by standard pull tests for a 35 micron (1 oz.) foil, an adhesion of 13 lbs. is typical between the substrate and the matte surface, but even after special treatment, only about 6 lbs. of adhesion is obtained between the second substrate and the smooth copper foil surface. This in turn has caused an unacceptably high incidence of delamination in finished multilayer circuit boards.

Delamination problems have long been recognized by the Printed Circuit ("PCB") industry, as evidenced by numerous journal articles. Examples of such articles including "Multilayer Problem Prevention Clinic" Electronic Packaging and Production, July 1982 pg. 211; "Printed Circuit Techniques", Insulation/Circuits, May 1981 pg. 25; and "Testing for Delamination Resistance of Multilayers" Insulation/Circuits July 1980.

To date, the proposed solutions to multilayer adhesion problems have usually involved some type of post deposition treatment step in which the smooth surface of the copper foil was chemically or electrochemically oxidized, or coated with an adhesion promoting additive. One such treatment is a post deposition process of the type taught by Luce et al in U.S. Patent 3,293,109 in which a surmounting powdery layer of copper-copper oxide particles are deposited in random clusters to form a plurality of projections adhering to the copper foil. While these techniques did indeed provide some improvement in adhesion, they still did not provide adhesion equivalent to that obtained on the matte side of the foil, and/or the often created new problems in the subsequent circuit board fabrication steps such as drilling, soldering and the like.

One copper foil defect which has been proved to be much more serious in fabricating multilayer boards is the so-called "pin hole" and/or porosity problem. It has long been known that electrodeposited copper foil tends to have porosity or minute pin holes, very small apertures, visible on close examination to the naked eye, generally having a diameter from about 10 micrometers (porosity) to as much as 100 micrometers (un holes). While these pin holes were a problem in fabricating conventional single layer circuit boards, they are much more serious in multilayer boards.

There have been many proposals directed to the production of pin hole free copper foil, but to date these proposals, as a practical matter, have only resulted in reduction in the number of pin holes, rather than their substantial elimination, which is what the PCB industry desires, and the multilayer applications now more urgently requires.

## IN THE DRAWINGS

Figure 1 is a schematic illustration of one of the preferred methods of making the novel copper foil of the present invention.

Figure 2 is a schematic illustration of an alternative method by which novel foil can be produced.

Figure 3 is a schematic illustration of yet another alternative method of producing the novel copper foil of the present invention.

Figures 4 and 5 are comparative scanning electron photomicrographs of the surface of each of the sides of a novel copper foil of the present invention.

Figure 6 is a photomicrograph of a crossection of a novel copper foil of the present invention.

## SUMMARY OF THE INVENTION

The present invention overcomes the problems heretofore encountered in adhesion of multilayer circuit boards and substantially eliminates pin holes, also providing a novel copper foil wherein both surfaces have a matte finish. The double matte foil of the present invention is produced by depositing a first layer of copper foil, of a predetermined thickness, using conventional electrodeposition techniques; removing the foil from the plating drum, and then depositing a second layer of copper foil onto the smooth surface of the first copper foil layer, thereby producing a composite foil having two matte finish sides. The composite foil can have a thickness generally in the range of from about 5 to about 50 microns, though it may be as thick as 350 microns or more, or may be as thin as is practical from the point of view of handling the unsupported foil. In general, the thickness of most commercial foils is between about 18 to 70 microns. The second deposit of copper foil should provide from about 1 to about 90% of the overall thickness of the final composite foil, preferably from about 25 to about 75%.

In addition to being substantially pin hole free, the foil of the present invention has a number of other unique advantages. The two layers may be of the same or different thickness, may be of copper having the same or different metalurgical properties; and may have substantially the same or a substantially different profile. "Profile" relates to the roughness of the matte finish of either side. A conventional foil having a thickness of about 18 microns (frequently referred to as "1/2 oz. foil") usually has a relatively low profile, i.e., a roughness (typically though not necessarily) of from about 3 to about 5 micrometers, while so-called 1 oz. foil has a relatively high profile i.e. about 10 to about 15 micrometers. In general, thinner foils tend to have a lower profile, and this is often deemed the more desirable profile, e.g. so-called 1/2 ounce deposits would usually be felt to have a substantially better profile than comparable 1 ounce foils. Thinner foils are also often thought to have more uniform impedance at high frequencies. The present invention can provide the ability to obtain a particular profile, i.e. the ability to provide where desired, a 1 ounce foil having a profile normally associated with 1/2 ounce foil or 1/4 ounce foil.

Following deposition, the foil may be subjected to various conventional post electrodeposition treatments to further improve adhesion, prevent substrate staining; or the like. For example, where an epoxy substrate is to be employed in fabrication of the printed circuit board, a thin layer of zinc, indium or brass may be employed as taught by Luce et al in U.S. Patent 3,585,010.

## PREFERRED EMBODIMENTS

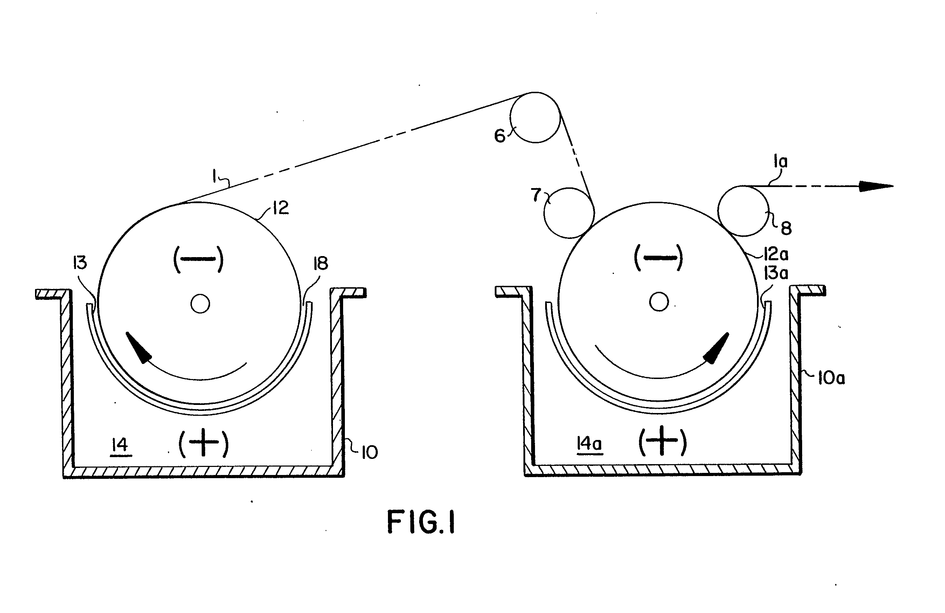

One of the preferred methods of producing the double matte foil of the present invention is illustrated in Figure 1. A first deposit of copper foil 1 is deposited on cathode drum 12 rotating clockwise past anodes 13 in a suitable electrolyte 14 within a conventional tank 10. Foil 1 which has a smooth surface on the side which was in contact with drum 12, is then passed over one or more handling means, such as illustrated roller means 6 and 7, into a second plating bath in tank 10a where the matte surface of foil 1 is placed in contact with cathode drum 12a rotating in tank 10a counterclockwise past anode 13a in electrolyte 14a. A further deposit of copper is thereby deposited onto Foil 1, producing composite Foil 1a, having a matte surface on both side. Foil 1a is passed by conventional handling means such as roller 8, to a take-up roller (not shown), and/or to one or more post deposition treatment baths well known to those skilled in the art, such as taught by Luce et al in aforementioned U.S. Patent 3,585,010.

More particularly, the apparatus illustrated in Figure 1 comprises two electrolytic cells. The first cell has a tank 10 formed from a suitable inert material such as lead or stainless steel. If desired, the tank 10 may be formed from an appropriate non-conducting material such as concrete and lined with a metal, such as lead or stainless steel, or a nonmetallic material such as polyvinylchloride or rubber. A drum cathode 12 is mounted for rotation by suitable conventional mounting means not shown. The drum cathode may be formed from any suitable electrically conductive metal or metal alloy including lead, stainless steel, columbium, tantalum, titanium and alloys thereof. In a preferred construction, the drum cathode comprises a stainless steel drum having a polished plating surface formed from titanium, chromium, columbium, tantalum, or an alloy thereof. The drum cathode 12 may be rotated by any suitable motor drive arrangement (not shown) known in the art.

The drum cathode 12 is mounted in the tank 10 so that it is at least partially immersed in an electrolyte solution 14. In a preferred arrangement, about half of the drum cathode extends beneath the surface of the electrolyte 14.

The electrolyte 14 generally comprises an acidic solution containing a concentration of ions of a metal to be electrodeposited. For example, where copper is to be electrodeposited, the electrolyte 14 contains a concentration of copper ions. In a preferred embodiment for forming nodularized copper foil or coral copper using the apparatus of the present invention, the electrolyte 14 comprises a copper sulfate-sulfuric acid and water solution. The solution, which is preferably maintained at an elevated temperature during operation, has a concentration of copper, of about 40 grams/liter, (hereinafter g/l); to about 140 g/l, preferably from about 60 g/l to about 100 g/l. In a preferred embodiment, the concentration of sulfuric acid for an electrolyte substantially at room temperature is from about 10 g/l to about 100 g/l,

It should be recognized that the aforementioned copper sulfate and sulfuric acid concentrations are dependent upon the electrolyte temperature. In the preferred embodiment the tank 10 is provided with means (not shown) for maintaining the electrolyte temperature at a desired level. The temperature maintaining means may comprise any suitable means known in the art such as a heating and/or cooling loop. At elevated temperatures, the copper sulfate concentration range may be increased beyond the aforementioned concentration range because its solubility limit increases with temperature. If desired, a proteinaceous material such as gelatin and/or a suitable surfactant may be added as is known in the art to the copper sulfate-sulfuric acid electrolyte to further modify the surface morphology.

At least one arcuate insoluble primary anode is mounted in the tank 10 in close proximity to the rotating drum cathode 12. The primary purpose of the anode or anodes is to complete the electrical cirucit and faciliate the reduction of copper ions on the drum surface of drum cathode 12 a relatively smooth deposit of metal from the electrolyte 14. While any number of primary anodes may be used, it is generally preferred to use two arcuate anodes and it is also preferred to arrange the primary anodes substantially concentric with the rotating drum cathode 12 and to space each anode from the surface of drum 12 by a distance of about 4 mm. to about 25 mm. Most preferably, each anode is spaced from the drum surface by a distance in the range of about 5 mm. to about 15 mm. The primary anode(s) may be mounted in the tank 10 by any suitable conventional mounting device or devices (not shown).

As well as being arranged in close proximity to the rotating drum cathode 12, the primary anode(s) is preferably arranged so as to form an electrolyte passageway 18. During the foil fabrication process, the electrolyte is caused to flow through the passageway 18 between the primary anode(s) and the drum surface by a pump or agitation means (not shown). Any suitable pump known in the art may be used to create this electrolyte flow. If desired, a manifold (also not shown) may be mounted in the tank 10 adjacent the entrance portion of the passageway 18 to assist in distributing electrolyte to the passageway 18.

During operation of the apparatus of the present invention, the electrolyte 14 is passed through the passageway 18 between the primary anode and the rotating drum cathode 12 at a desired flow rate. A first current sufficient to generate a desired base current density is applied to the primary anode(s) by a first power supply. Generally, the base current density should be below the limiting current density. As a result of the current applied to the primary anode(s), metal from the electrolyte 14 is deposited onto the drum surface 30 in the first plating zone. Since the base current density is preferably less than the limiting current density, a relatively smooth metal deposit having a substantially uniform thickness, e.g. a metal foil, forms on the drum surface.

The primary anode(s) may be formed from any suitable electrically conductive material known in the art. For example, they can be formed from a variety of metals particularly lead or alloys therof well known in the art. The anodes may also be so-called "dimensionally stable anodes" or "DSA" such as those disclosed and claimed in U.S. Patent Nos. 3,265,526, 3,632,498 and/or 3,711,385. If a plurality of anode members are employed, they are electrically connected to a common first power supply. Any suitable electrical connection can be made between the power supply and anode or anode members.

The foregoing also describes the second electrolytic cell, its corresponding elements 10a, 12a, 13a, 14a, and their operation. These elements which fall generally within the foregoing ranges and alternatives may be the same as the corresponding elements of the first electrolytic cell, or one or more or all of them may be different. This is especially true as to electrolyte 14a, particularly where the composite is to be formed of copper having different metallurgical properties.

Any suitable power supply known in the art may be used in operating the electrolytic cells. For example, a single power supply, or two separate power supplies may be employed, and each power supply could be a rectifier for applying a DC current or a variable power supply having means for generating a current having a regularly recurring pulse wave such as a sine wave, a square wave, a triangular wave or any other desired waveform.

Current density is, in part, a function of electrolyte flow, and as the electrolyte flow rate increases, a higher current density may be employed without charging the characteristics of the metal foil being deposited.

After deposition has been completed, the metal foil 1 or 1a may be removed from the drum cathode 12 or 12a in any suitable manner known in the art. For example, a knife blade not shown may be used to strip the foil from the drum cathode. Thereafter, the foil may be rinsed, dried, slit to size, rolled onto a take-up reel 19 and/or passed onto one or more treatment zones for one or more additional treatments, such as for example taught by U.S. Patent 3,585,010 noted hereinbefore.

EXAMPLE

Two segments of 17 to 18 micron copper foil, each having an area of approximately 100 sq. ft. were produced on a 5 ft. diameter drum in a copper sulfate bath as described hereinbefore. On examination the segments were found to have 17 to 22 pin holes respectively. Each segment was subsequently placed back into the electrolytic cell with the matte side on the cathode drum, and an additional 17 to 18 microns of copper was plated onto the privious smooth surface, to provide in each case, a 35 micron foil having an area of approximately 100 sq. ft. having a matte surface on each side. On examination both samples were found to be completely free of pin holes or porosity.

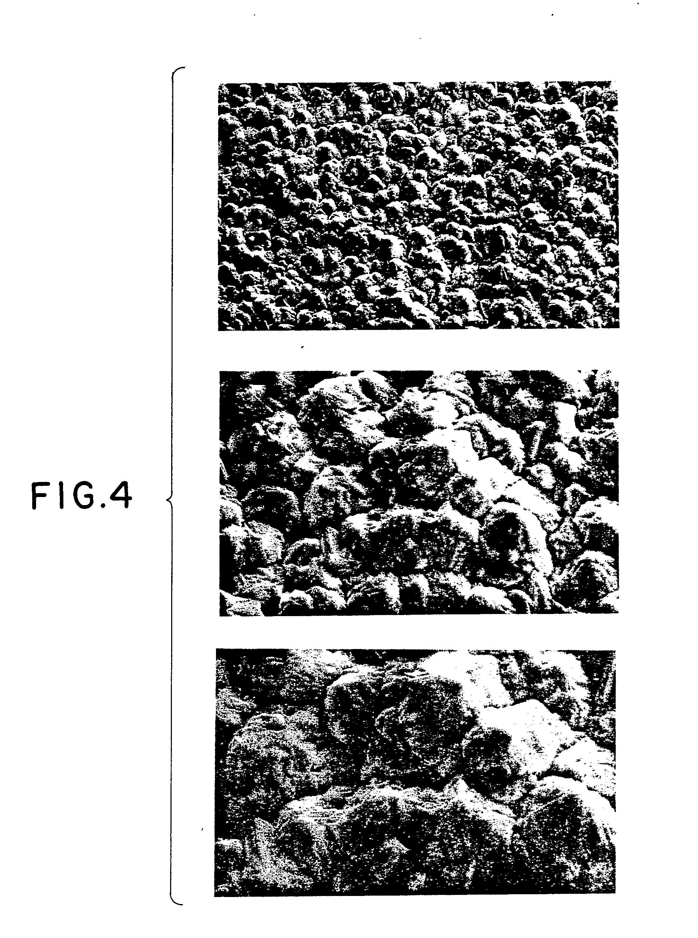

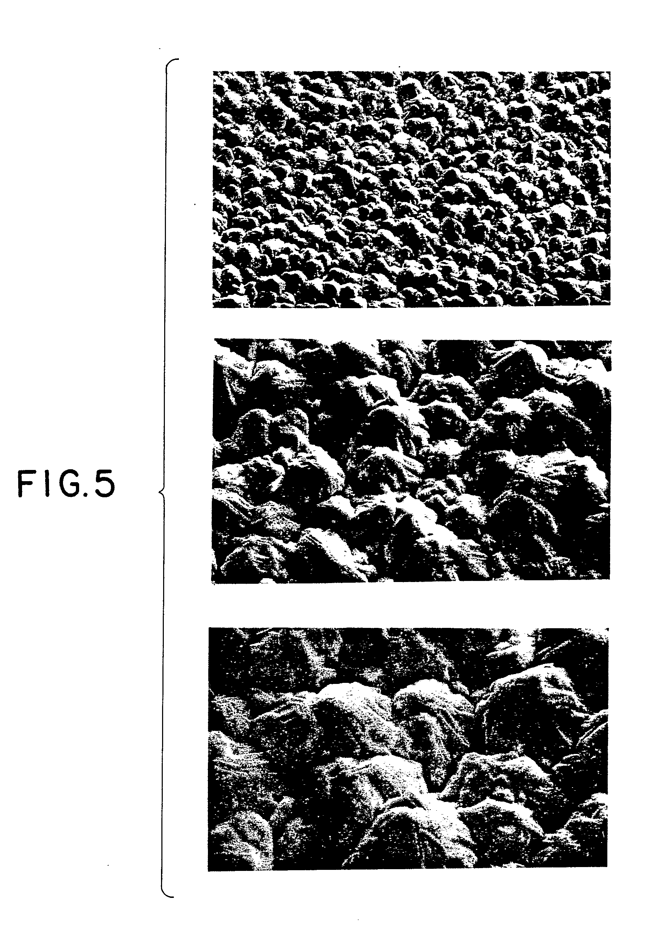

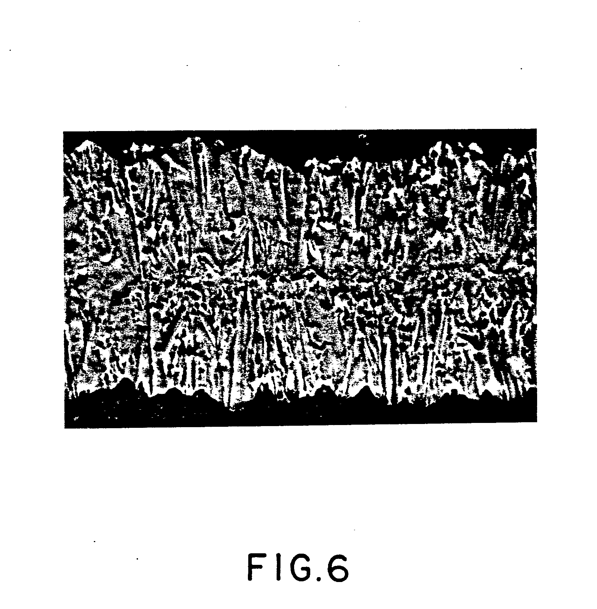

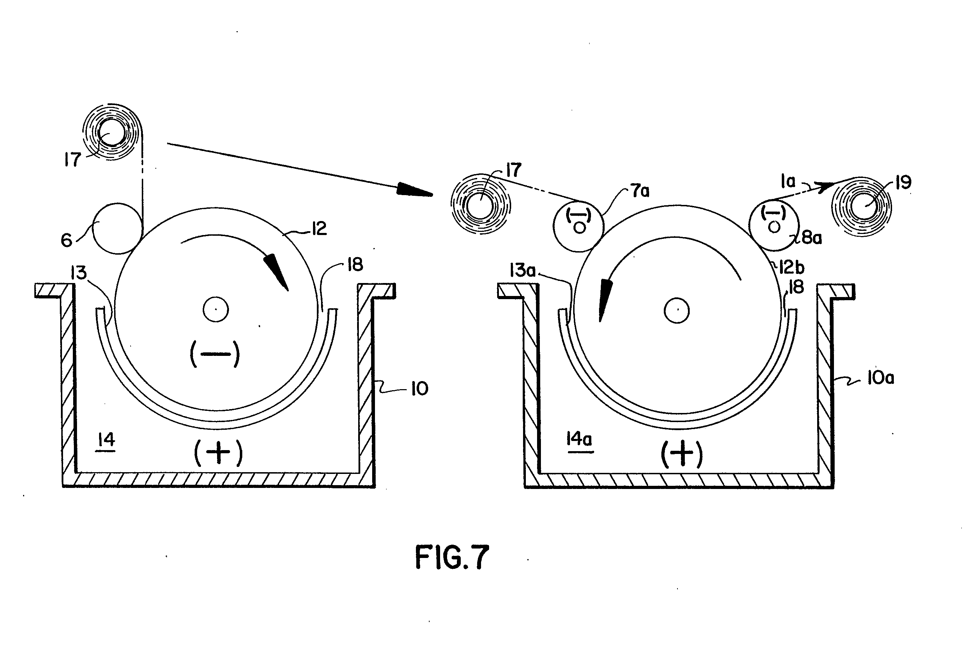

One of the samples produced in the foregoing Example was subjected to photomicrographic examination. The photomicrographs of Figure 4 show a 1000x, a 3000x, and a 5000x enlargement of one side of the sample, while Figure 5 shows a similar series of enlargements of the other side. It will be seen that the two sides have substantially the same matte surface. Measurement of the surface roughness indicated that (in mocrometers) side 1 was 6.83 in the the longitudinal direction, and 5.95 in the transverse direction, while side 2 was 6.07 in the longitudinal direction and 6.29 in the transverse direction. Photomicrograph was also made of a crossection of the sample, and this is shown in Figure 6. It will be seen in Figure 6 that the elongated grains of copper in the second of the two layers appears to directly align with the grains in the first layer.

On examination at room temperature, the foil had a nomial thickness of approximately 1.3 nils; an ultimate tensile strength of 57.61K psi (35.61 K psi to 0.2% yield) and an elongation of 9.6% in the longitudinal direction; and an ultimate tensile of 57.23K psi (35.57 K psi to 0.2% yield) and an elongation of 7.08 in the transverse direction.

While the cell of Fig. 1 has been shown as having a single primary anode 13 forming a central fluid passageway 18, two or more ibnsoluble arcuate anodento shown may be used in lieu of the single anode 13. Where a single anode is used, one or more openings are usually provided in the central portion of the anode to permit electrolyte flow into the gap 18 between the rotating drum surface and the anode surface

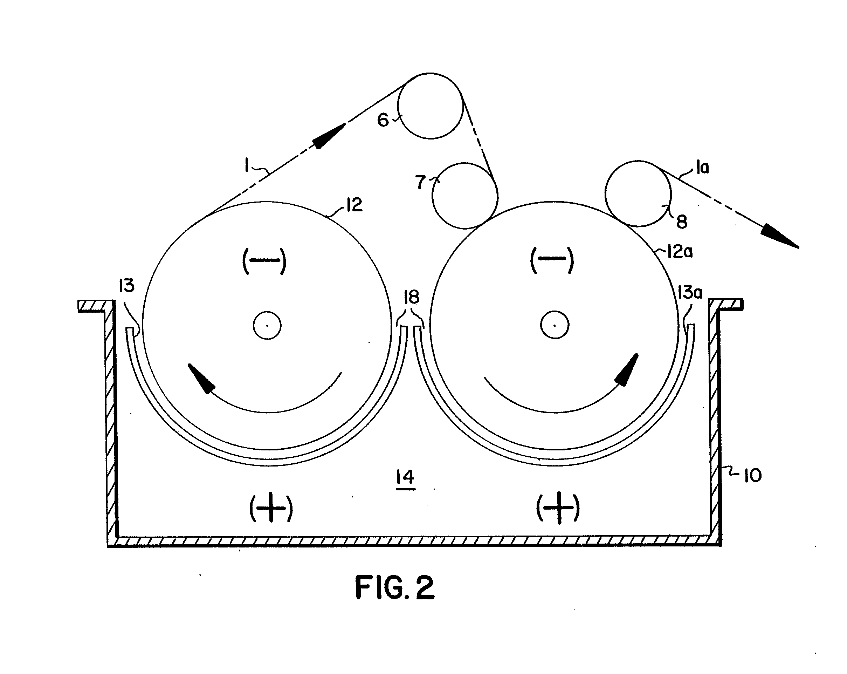

In the embodiment illustrated by Figure 2, cathode drums 12 and 12a are disposed within a common electrolyte 14 within a single plating tank 10. This embodiment is particularly useful in those applications where it is not essential to use different electrolyte bath compositions to vary the metalurgical proportions of the two copper deposits.

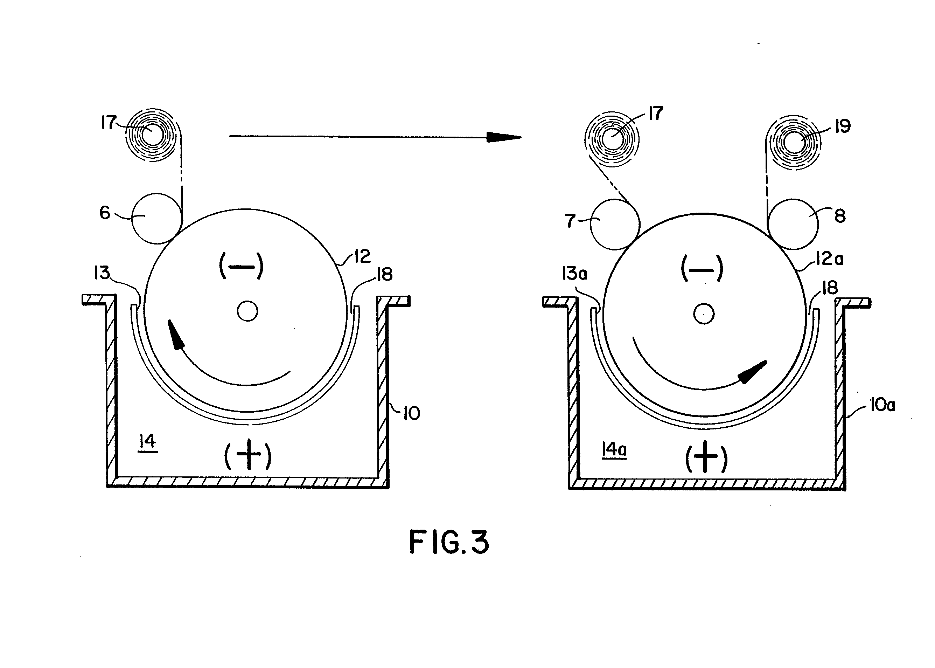

While the invention has been described above in terms of a continuous foil production system, the metal foil may also be produced in a batchwise fashion if it is so desired. This embodiment is illustrated not only by the example above, but also by Figure 3. In the embodiment illustrated in Fig. 3, foil 1 is collected on takeup roll 17, and later fed from takeup roll 17 into the second electrolytic cell 10a with the matte side of foil 1 in contact with drum 12a. As shown in this embodiment, foil 1a is collected on takeup reel 18.

The metal foil procuced by the present invention may be laminated to an appropriate substrate. As will be apparent, the particular substrate used in the laminate will vary depending upon the use of which the laminate is intended and the service conditions under which the laminate will be used. Particularly approprate substrates include polytetrfluorethylene-impreganted fiberglass, polyimides, fiberglass impregnated by certain fluorocarbon products including polymers of trifluorochloroethlene and certain copolymers, and the like. Where the foil is to be bonded to an epoxy substrate, it is as earlier noted highly desirable to provide a barrier coating on the copper foil as taught in our earlier U.S. Patent 3,585,010. If needed, an adhesive may be used to bond the treated foil to the substrate. Any suitable conventional technique known in the art may be used to bond the treated foil to the substrate.

While the preferred embodiment of the invention has been descrbied in connection with the production of copper foil, the technique of the present invention is also applicable to the electrodeposition of other metals including but not limited to lead, tin, zinc, iron, nickel, gold and silver. Of course, the type of elecrolyte, the metal and acid concentrations in the electrolyte, the flow rate, and the current densities used will have to be altered in accordance with the metal being plated.

While the cathode for the plating apparatus has been described as being a rotating drum cathode, it is as earlier noted possible to perform the process of the present invention using an endless belt-type cathode, i.e., a carrier support.

The patents, patent application and foreign patent pubications set forth in the specification are intended to be incorporated by reference herein.

It is apparent that there has been provided in accordance with this invention a process and apparatus for producing a double matte finish metal foil which fully satisfies the objects, means and advantages set foth hereinbefore, While the invention has been described in combination with the specific embodiments thereof, it is evidenced that many alternatives, modifications, and variations will be apparaent to those skilled in the art in light of the foregoing description. Accordingly, it is intended to embrace all such alternatives, modications and variations as fall within the scope of the appended claims.

### Claims

1. A copper foil produced by electrodeposition, having opposed first and second surfaces of a matte finish.

2. A copper foil comprising a composite of a first layer of electrodeposited copper having opposed first and second surfaces, said first surface having a matte finish, and a second layer of copper electrodeposited on to the second surface of said first layer, said second copper layer having a matte finish on its exposed surface thereby providing a copper foil having two opposed matte finish surfaces.

3. A copper foil according to claim 2, wherein said composite foil has a thickness of less than about 350 microns.

4. A copper foil according to claim 2, wherein said composite foil has a thickness of from about 5 to about 70 microns.

5. A copper foil according to claim 3 wherein said first layer comprises from about 1 to about 99% of the average overall thickness of the composite.

6. A copper foil according to claim 4, wherein said first layer comprises from about 1 to about 99% of the average overall thickness of the composite.

7. A copper foil according to claim 3, wherein said first layer comprises from about 25 to about 75% of the average overall thickness of the composite.

8. A copper foil according to claim 4, wherein said first layer comprises from about 25 to about 75% of the average overall thickness of the composite.

9. A copper foil according to claim 2, wherein said first layer is electrodeposited in a first electrodeposition bath, and said second layer is electrodeposited in a second electrodeposition bath.

10. A copper foil according to calim 4, wherein said matte finish has an average roughness of from about 2 to about 20 micrometers.

11. A copper foil according to claim 8, wherein said matte finish has an average roughness of from about 2 to about 20 micrometers.

12. A copper foil according to claim 4, wherein said matte finish has an average roughness of from about 3 to about 15 micrometers.

13. A copper foil according to claim 8, wherein said matte finish has an average roughness of from about 3 to about 15 micrometers.

14. A method of producing a copper foil having two matte surfaces, the steps which comprise depositing a first layer of copper foil, of a predetermined thickness having one matte surface and one smooth surface; removing the foil from the plating drum, and then depositing a second layer of copper foil on to the smooth surface of the first copper foil layer, thereby producing a composite foil having two matte finish surfaces.

15. The process according to claim 14, wherein said first layer of copper foil is fed to a second cathode plating drum, where said matte surface of said first layer is caused to come into contact with said plating drum, and said plating drum is caused to rotate past at least one anode, whereby a second layer of copper is electrodeposited on to the smooth surface of the first layer of copper foil.

16. The process according to claim 15, wherein said first layer of copper foil is continuously fed to said second plating drum.

17. The process according to claim 15,wherein said first plating drum and said second plating drum are within a common plating tank containing a single electrolyte.

18. The process according to claim 15, wherein said first plating drum and said second plating drum are located in separate plating tanks, each containing a separate electrolyte.

19. The process according to claim 16, wherein said first plating drum and said second plating drum are located in separate plating tanks, each containing a separate electrolyte.

20. The process of claim 19, wherein the electrolytes in the two separate plating baths have different plating bath compositons.

FIG.1

0 250 195

**FIG. 2**

FIG.3

FIG.4

FIG.5

FIG.6

FIG.7

0 250 195